# FASCICULE DE BREVET EUROPEEN

(11) **EP 1 058 946 B1**
(45) Date de publication et mention de la délivrance du brevet: **16.07.2008**
(21) Numéro de dépôt: 99901672.8
(22) Date de dépôt: 01.02.1999
(51) Int. Cl.: H01L 21/20, H01L 21/762, H01L 21/265

(54) **PROCEDE DE FORMATION DE CAVITES DANS UN SUBSTRAT SEMICONDUCTEUR, PAR IMPLANTATION D'ATOMES**
VERFAHREN ZUR BILDUNG VON HOHLRÄUMEN IN EINEM HALBLEITERSUBSTRAT, MITTELS ATOM-IMPLANTATION
METHOD FOR FORMING CAVITIES IN A SEMICONDUCTOR SUBSTRATE BY IMPLANTING ATOMS

(30) Priorité: 02.02.1998 FR 9801172
(43) Date de publication de la demande: 13.12.2000
(73) Titulaire: S.O.I.Tec Silicon on Insulator Technologies, 38190 Bernin (FR)
(72) Inventeur: AUBERTON-HERVE, André-Jacques, F-38120 Saint-Egrève (FR)
(74) Mandataire: Texier, Christian
(86) Numéro de dépôt international: PCT/FR1999/000197
(87) Numéro de publication internationale: WO 1999/039378

(56) Documents cités:
- EP-A- 0 703 609
- EP-A- 0 801 419
- GB-A- 2 211 991
- US-A- 5 374 564
- PATENT ABSTRACTS OF JAPAN vol. 010, no. 034 (P-427), 8 février 1986 & JP 60 182090 A (FUJITSU KK), 17 septembre 1985
- PATENT ABSTRACTS OF JAPAN vol. 010, no. 264 (P-495), 9 septembre 1986 -& JP 61 087296 A (FUJITSU LTD), 2 mai 1986

## Description

La présente invention concerne le domaine des substrats, notamment pour composants électroniques ou optiques. Plus précisément, elle concerne un procédé pour préparer des substrats, notamment semi-conducteurs, qui seront utilisés pour réaliser ces composants, ou même un procédé contribuant à la réalisation de ces composants eux-mêmes sur un substrat.

On connaît déjà, par le document US 5 374 564 de M. Bruel, un procédé de fabrication de films minces de matériaux semi-conducteurs comprenant l'exposition d'une plaquette de matériau semi-conducteur,
- à une étape de bombardement d'une face du substrat avec des ions, afin d'implanter ces ions en concentration suffisante pour créer une couche de microcavités,
- à une étape de mise en contact intime de cette face du substrat avec un raidisseur, et
- à une étape de traitement thermique pour générer un clivage du substrat au niveau de la couche de microcavités.

Ce procédé est par exemple utilisé pour la réalisation d'un film mince de silicium sur isolant, ce film mince étant constitué de la partie du substrat restée sur le raidisseur après clivage.

Avec ce type de procédé, la zone où s'effectue l'implantation est perturbée, ce qui conditionne l'homogénéité du film mince et sa rugosité au niveau des surfaces situées de part et d'autre de la surface de clivage. Il est donc ensuite nécessaire de réaliser des traitements pour éliminer les défauts, les rugosités, etc.. Ces traitements consistent, par exemple, à polir les surfaces et/ou guérir la structure cristalline par recuit. Or, plus les zones perturbées sont étendues en profondeur, plus ces traitements sont longs et plus l'hommogénéité d'épaisseur du film mince et du substrat restant après clivage, en est affectée.

D'autre part, il est connu que l'on peut utiliser les micropores du silicium poreux pour réaliser des composants électroluminescents ou photoluminescents. Or, ces micropores obtenus par des moyens électrochimiques présentent une étendue et une taille importantes qui peuvent limiter la qualité des phénomènes luminescents que l'on cherche à exploiter. II serait donc avantageux de disposer de substrats semi-conducteurs, ayant des cavités dont les dimensions sont mieux contrôlées et s'étendent sur une profondeur mieux localisée, afin de réaliser des composants luminescents présentant de meilleures performances.

Les documents EP-A-0 801419, EP-A-0 703 609, US-A-5 374 564, JP 60 182090 A, JP 61 087296 A et GB-A-2 211 991 décrivent des procédés d'implantation d'espèces dans un substrat pour obtenir une couche implantée à une profondeur déterminée.

Un but de la présente invention est de proposer un procédé permettant de mieux contrôler la localisation, la formation et la croissance de cavités.

Ce but est atteint selon l'invention, grâce à un procédé de traitement de substrats, notamment semi-conducteurs, par implantation d'atomes, dans le but de créer dans un substrat, des cavités à une profondeur contrôlée comprenant les étapes consistant à:
- implanter des atomes dans le substrat a une première profondeur, pour obtenir une première concentration d'atomes à cette première profondeur ;
- implanter des atomes et former un réservoir d'atomes dans le substrat à une deuxième profondeur différente de la première, pour obtenir à cette deuxième profondeur, une deuxième concentration d'atomes, inférieure à la première;
- effectuer sur le substrat, un traitement mis en oeuvre pour faire migrer vers la première profondeur, au moins une partie des atomes implantés à la deuxième profondeur, de manière à générer les cavités à la première profondeur.

Lorsque l'on fait pénétrer des atomes dans un substrat à partir d'une surface de ce substrat, par exemple par implantation, ils se distribuent dans celui-ci. La concentration de ces atomes dans le substrat a un profil de distribution en fonction de la profondeur qui forme un pic avec un maximum à une certaine profondeur. Ce pic a une largeur, pour une concentration donnée, qui est d'autant plus importante que le nombre d'atomes ayant pénétré dans le substrat est important. La présence de ces atomes dans le substrat perturbe celui-ci et l'étendue de la zone perturbée est d'autant plus grande que le pic, à une concentration donnée, est large. Or, certains effets particuliers, comme une fragilisation du substrat suffisante pour pouvoir le cliver, ou la formation de microcavités pour obtenir un effet luminescent, etc., nécessitent une concentration en atomes implantés importante dans la zone où l'on souhaite obtenir l'effet recherché. C'est dans ce type de cas que le procédé selon l'invention est particulièrement intéressant, car il permet de limiter l'étendue en profondeur de la zone perturbée, tout en atteignant la concentration nécessaire à l'obtention des effets désirés.

Le procédé selon l'invention consiste lors d'une étape, à implanter des atomes dans le substrat pour obtenir une première concentration d'atomes formant un premier pic avec une première largeur et un premier maximum situé à une première profondeur. En limitant le nombre d'atomes implantés à cette étape, on peut réduire la largeur, pour une concentration donnée, du profil de concentration. Ceci se traduit par une réduction de l'étendue en profondeur de la zone la plus perturbée par les atomes implantés.

Lors d'une autre étape du procédé selon l'invention, des atomes sont implantés dans le substrat à une deuxième profondeur différente de la première, pour obtenir à cette deuxième profondeur, une deuxième concentration d'atomes, inférieure à la première. On constitue ainsi un réservoir d'atomes implantés, de perturbations structurelles telles que des défauts ou des lacunes générés par les atomes implantés, d'espèces chimiques liées à des atomes implantés, etc., que l'on peut ensuite faire migrer ou reporter dans le voisinage de la première profondeur. Le nombre d'atomes implantés dans ce réservoir est adapté pour que la somme des atomes implantés à la première et à la deuxième profondeurs soit suffisant pour réaliser des cavités à la première profondeur, après un traitement apte à faire migrer, vers la première profondeur, au moins une partie des atomes implantés à la deuxième. Il est entendu que ce traitement peut aussi reporter, de la deuxième profondeur vers la première profondeur, des perturbations structurelles, telles que des défauts ou des lacunes générées par les atomes implantés, et des espèces chimiques liées aux atomes implantés (V-H₄). Nous utiliserons par la suite, l'expression générique « espèces liées aux atomes implantés », pour désigner l'ensemble de ces perturbations et de ces espèces chimiques liées aux atomes implantés.

Avec le procédé selon l'invention, on peut donc réduire la largeur du pic réalisé à la première profondeur, en implantant dans le substrat moins d'atomes lors de l'étape d'implantation correspondante, mais obtenir le nombre d'atomes nécessaires à l'obtention de l'effet souhaité, dans le voisinage de la première profondeur par l'apport des atomes implantés, et des diverses espèces liées aux atomes implantés, ayant migré à partir du réservoir.

D'autres aspects, buts et avantages de la présente invention apparaîtront à la lecture de la description détaillée qui suit.

L'invention sera aussi mieux comprise avec l'aide des références aux dessins sur lesquels :
- la figure 1 représente schématiquement les étapes d'un exemple de mise en oeuvre, non limitatif, du procédé selon l'invention ;
- la figure 2 représente un profil de dispersion de la concentration C en ions implantés en fonction de la profondeur P dans le substrat, ce profil correspondant à un mode de mise en oeuvre d'un procédé de la technique antérieure ;
- la figure 3 représente schématiquement le profil de dispersion de la concentration C en atomes implantés en fonction de la profondeur P, dans le substrat, par la mise en oeuvre d'un procédé de la technique antérieure ;
- la figure 4 représente, sur un même diagramme, le profil déjà représenté à la figure 2 et un profil de dispersion de la concentration C en atomes implantés en fonction de la profondeur P, ce profil correspondant à un mode de mise en oeuvre conforme à l'invention ;
- la figure 5 représente schématiquement le profil de dispersion de la concentration C en atomes implantés en fonction de la profondeur P, dans le substrat, par la mise en oeuvre d'un procédé conforme à la présente invention ; et
- la figure 6 représente, sur un même diagramme, un autre profil de dispersion de la concentration C en atomes implantés en fonction de la profondeur P, ce profil correspondant à un mode de mise en oeuvre conforme à l'invention.

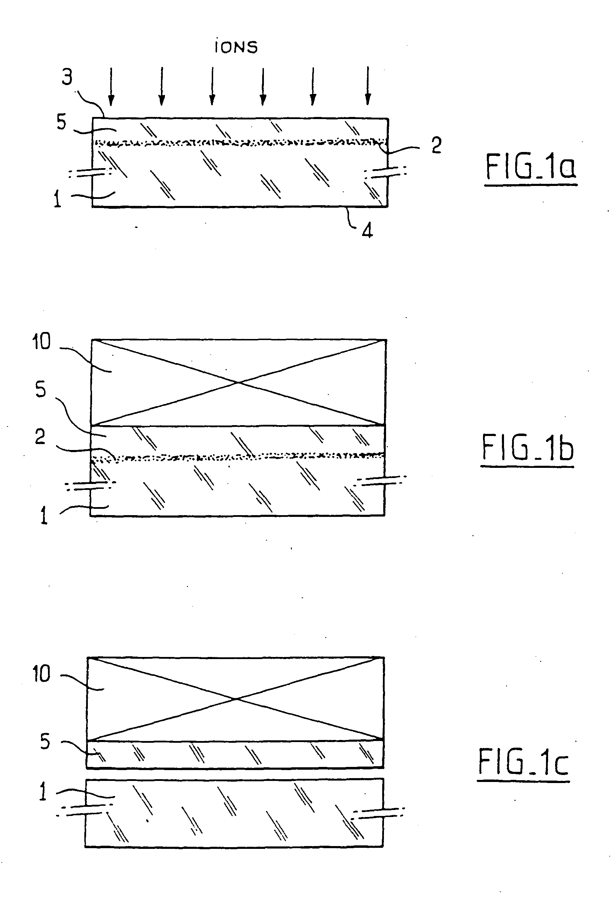

Selon un mode de mise en oeuvre particulier, mais non limitatif, du procédé selon l'invention, représenté sur la figure 1, celui-ci est utilisé pour la préparation d'un film mince 5, notamment de matériau semi-conducteur.

Plus précisément encore, le mode de mise en oeuvre du procédé selon l'invention, détaillé ci-dessous, concerne la réalisation de microcavités dans des substrats 1, pour obtenir par exemple des films minces 5 de silicium sur isolant.

Par la suite, nous désignerons par microcavités des défauts ou des cavités dans le substrat 1, créés par un ou plusieurs atomes implantés. La forme et la taille des microcavités peuvent être très variables. La forme de ces microcavités peut être globalement sphérique. On parle alors de microbulles. Mais plus généralement, les microcavités ont une forme de lentille, de cylindre aplati ou une forme plus irrégulière. Leur taille est de l'ordre du nanomètre à quelques centaines de nanomètres. Ces microcavités peuvent contenir une phase gazeuse libre et /ou des atomes du matériau formant les parois des microcavités. Ces microcavités sont généralement appelées, dans la terminologie anglo-saxone, « platelets », « microblisters » ou « bubbles ».

Par la suite, nous désignerons par le terme « atome », l'atome aussi bien sous sa forme ionisée que sous sa forme neutre, voire sous une forme moléculaire.

Un substrat 1 de matériau semi-conducteur est soumis à une étape d'implantation d'atomes pour créer une couche au niveau de laquelle seront formées des microcavités 2 et une couche réservoir (figure 1a) ; éventuellement à une étape de mise en contact intime d'une face 3 du substrat 1 avec un raidisseur 10 (figure 1b) ; et une étape de traitement thermique ou recuit qui permet la diffusion des atomes, et des diverses espèces liées aux atomes implantés, de la couche réservoir vers la couche de microcavités pour faire croître les microcavités (figure 1 c). Cette croissance des microcavités induit des contraintes et la coalescence de certaines d'entre elles. Ce qui aboutit au clivage du substrat 1 au niveau de la couche de microcavités 2.

Comme représenté sur la figure 1, le substrat 1 de matériau semi-conducteur a, par exemple, la forme d'une plaquette, ayant deux faces principales 3, 4 parallèles, dont les dimensions sont très largement supérieures à la distance qui sépare ces deux faces 3, 4, c'est à dire à l'épaisseur de la plaquette. Cette plaquette a par exemple un diamètre de 200 mm (8 pouces) et une épaisseur de 725 µm. Le matériau semi-conducteur est par exemple du silicium monocristallin, dont les faces 3 et 4 sont parallèles aux plans cristallographiques (100).

Le film mince 5 est obtenu à partir du substrat 1. Le film mince 5 est constitué de la matière comprise entre l'une 3 des deux faces 3, 4 et la couche de microcavités 2, au niveau de laquelle le clivage va être provoqué.

L'étape d'implantation des atomes de la couche de microcavités 2 et de la couche réservoir est réalisée préférentiellement en procédant à un bombardement d'ions sur la face 3 du substrat 1 (figure 1 a). Ceci est réalisé grâce à un implanteur ionique dont le but est d'accélérer des atomes avec une énergie adaptée à la profondeur d'implantation souhaitée. On peut par exemple procéder à une immersion du substrat 1 dans un plasma en utilisant un champ électrique accélérateur au voisinage du matériau à implanter. On peut aussi envisager, sans s'éloigner de l'esprit de l'invention, de procéder à une implantation par diffusion des espèces atomiques à implanter, dans le substrat 1. Dans ce cas, le profil de distribution de la concentration en fonction de la profondeur dans le substrat 1, n'est plus un pic de type gaussien, mais prend plutôt la forme d'une distribution de Poisson. On appelle alors « profondeur d'implantation », le maximum de cette distribution.

Si un implanteur ionique est utilisé, le choix de la tension d'accélération des ions permet de contrôler leur profondeur d'implantation. Les ions accélérés pénètrent dans le substrat 1 où ils subissent des chocs avec les atomes de silicium, ainsi qu'un freinage électronique. Ils interagissent donc avec les atomes de silicium et éventuellement créent des liaisons chimiques avec ceux-ci (des liaisons Si-H par exemple, lorsque l'atome implanté est de l'hydrogène).

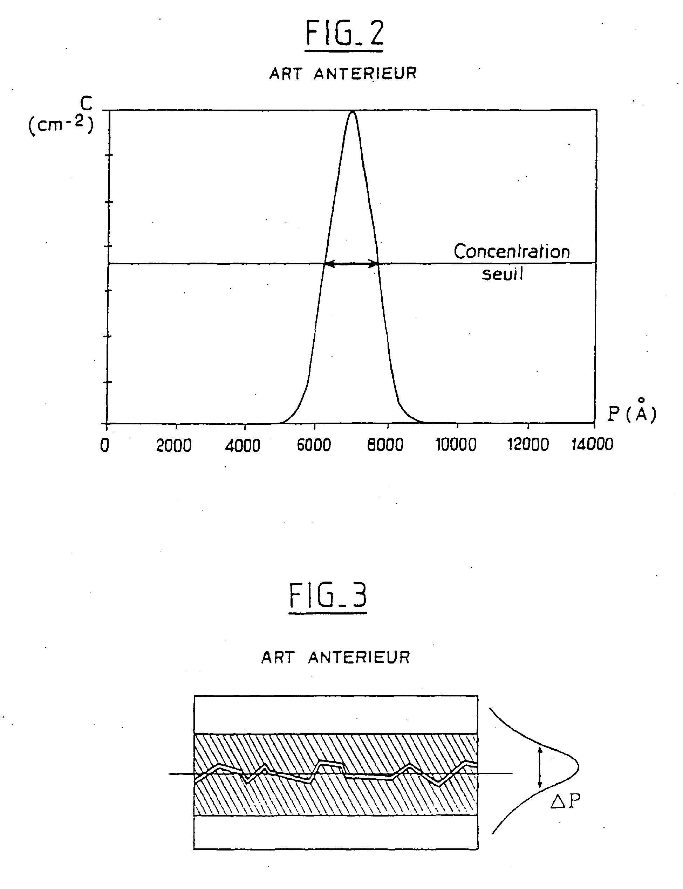

Les deux modes d'interaction, c'est à dire les chocs des atomes implantés avec les atomes de silicium et le freinage électronique, induisent une distribution de la concentration en atomes implantés en fonction de la profondeur d'implantation. Le profil de distribution de la concentration des atomes implantés en fonction de la profondeur d'implantation présente un maximum (figures 2, 4 et 6). Ce profil est grossièrement de type gaussien, mais il répond à des lois statistiques plus complexes. Ce profil présente une largeur, pour une concentration donnée, d'autant plus grande que la dose d'atomes bombardant la surface de la face 3 est importante. Cette dose détermine la concentration en atomes implantés dans le substrat 1 à une profondeur donnée. A titre d'exemple, lorsque la face 3 d'une plaquette de silicium monocristallin, correspondant à un plan cristallographique (100), est soumise à un bombardement d'ions H⁺ accélérés sous une tension de 150 kV, les atomes implantés se distribuent avec un maximum de concentration qui est situé à environ 1,3 µm de la face 3.

II existe une concentration seuil en atomes implantés au delà de laquelle des microcavités, ou des précurseurs à la croissance de ces microcavités, sont formés avec une taille et en nombre suffisants, pour que la zone où cette concentration seuil est atteinte soit une zone privilégiée de croissance et de coalescence des microcavités, lorsqu'est effectué un traitement, préférentiellement thermique, apte à faire migrer des atomes implantés et diverses espèces liées aux atomes implantés, au voisinage de cette zone.

Les zones où cette concentration seuil est atteinte ou dépassée, sont aussi celles où interviendront les perturbations les plus importantes et le clivage. C'est l'étendue en profondeur de ces zones qu'il est avantageux de minimiser.

Dans le mode de mise en oeuvre de l'art antérieur, le bombardement était prolongé en conservant la même tension accélératrice au delà de la concentration seuil, jusqu'à obtenir la concentration en atomes implantés, nécessaire au clivage. De cette manière, on obtenait un seul pic dans le profil de distribution de la concentration en atomes implantés en fonction de la profondeur. La largeur de ce pic unique et son maximum étaient relativement importants (figure 2). La zone perturbée, de largeur ΔP, qui en résultait, était en conséquence aussi relativement étendue en profondeur (figure 3). Il s'ensuivait aussi une rugosité importante au niveau des surfaces de part et d'autre du plan de clivage, ainsi que des défauts d'homogénéité du matériau sur une profondeur substantielle à partir de l'interface de clivage.

Dans le mode de mise en oeuvre conforme à la présente invention, on procède à une implantation d'atomes avec une première énergie. On obtient un premier pic de distribution de la concentration en fonction de la profondeur d'implantation. Ce premier pic présente un maximum, à la première profondeur, qui correspond à une première concentration maximale. Le bombardement à cette première énergie est arrêté de préférence avant que la concentration atomique seuil n'ait été atteinte. Autrement dit, après l'arrêt du bombardement à cette première énergie, les atomes sont encore en concentration insuffisante dans la région du substrat 1, voisine du maximum du pic de concentration, pour générer des microcavités en taille et en nombre suffisants pour obtenir un clivage dans des conditions souhaitées.

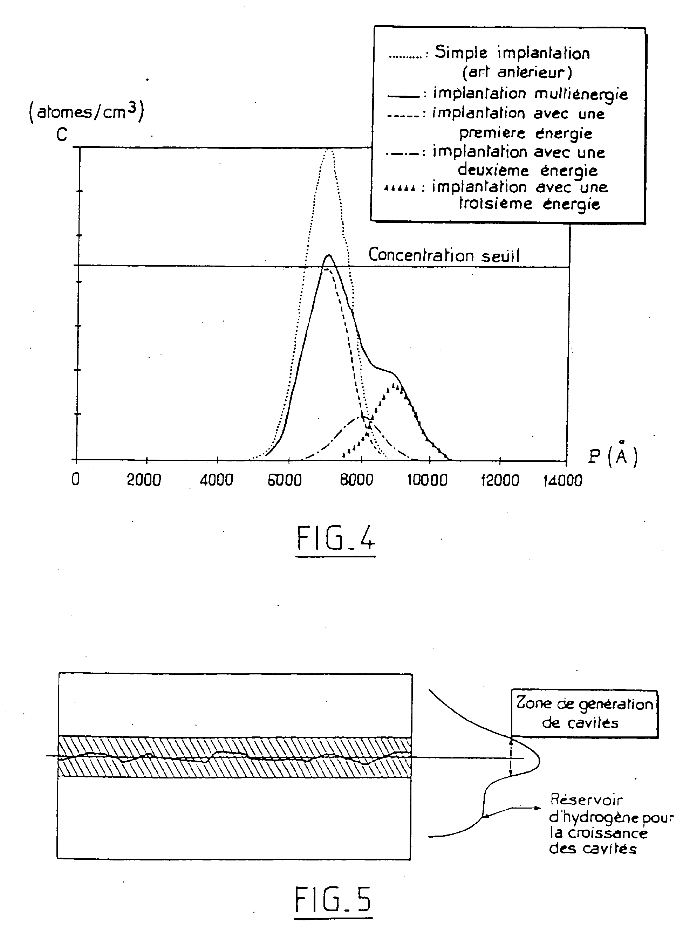

Dans le mode de mise en oeuvre de l'invention décrit ici, on réalise ensuite une deuxième et de préférence une troisième implantations, respectivement à une deuxième et une troisième énergies, différentes entre elles et différentes de la première énergie. Un exemple de profil de distribution de la concentration C en atomes implantés, en fonction de la profondeur P dans le substrat 1, à partir de la surface 3, obtenue pour ce mode de mise en oeuvre de l'invention avec trois énergies d'implantation est représenté sur la figure 4. Pour comparaison avec l'art antérieur, est aussi représenté sur la figure 4, le profil de distribution de la figure 2, obtenu avec une implantation avec une seule énergie. Sur cette figure est aussi tracé un trait parallèle à l'axe des abscisses, au niveau de la concentration seuil en atomes implantés.

Conformément à l'invention, les atomes bombardés sur la face 3 du substrat 1 avec les deuxième et troisième énergies, sont implantés avec des concentrations maximales inférieures à la concentration maximale en atomes implantés à la première énergie. Après l'implantation aux deuxième et troisième énergies, la concentration atomique totale maximale est supérieure à la concentration seuil.

A titre d'exemple, avec des ions H⁺, implantés dans du silicium orienté (100), avec une énergie comprise entre 60 et 80 keV, la concentration seuil est dépassée dans une zone s'étendant en profondeur sur une distance inférieure à 600 Å, alors qu'avec le procédé selon l'art antérieur, cette distance était supérieure à 800 Å.

Avantageusement, pour déplacer la zone perturbée vers la partie du substrat 1 qui sera éliminée après clivage, les deuxième et troisième énergies sont supérieures à la première énergie.

Les microcavités les plus stables sont celles présentes dans la zone où les atomes implantés sont en plus forte concentration, c'est à dire la zone où ils ont été implantés avec la première énergie. Cette zone est appelée zone de génération de cavités. Des défauts, et des microcavités situées dans les régions du substrat 1 voisines de la zone de génération de cavités, migrent vers les microcavités de cette zone, lors du traitement thermique. La zone à partir de laquelle les atomes implantés, et les diverses espèces liées aux atomes implantés, migrent vers la zone de génération de cavités, est appelée réservoir. Ainsi, en adaptant le nombre d'atomes implantés aux deuxième et troisième énergies, pour qu'ils constituent un réservoir d'atomes suffisamment important, la croissance des microcavités peut s'effectuer jusqu'à leur coalescence et/ou jusqu'à ce que les contraintes induites par cette croissance puissent provoquer un clivage du substrat 1 au niveau de la zone de génération de cavités.

La figure 5 représente schématiquement la zone de génération de cavités et le réservoir au regard du profil de distribution de la concentration en atomes implantés.

Dans l'exemple de mise en oeuvre du procédé selon l'invention illustré par la figure 4, le nombre d'atomes implantés à la première profondeur est supérieur au nombre d'atomes implantés aux deuxième et troisième profondeurs, et le nombre d'atomes implantés à la deuxième profondeur est inférieur au nombre d'atomes implantés à la troisième profondeur. Dans cet exemple, la dose totale d'atomes implantés avec les première, deuxième et troisième énergies est égale à celle utilisée dans le cas de l'implantation à une seule énergie, de la technique antérieure.

Le procédé de préparation de films minces selon l'invention est optimisé en calibrant les concentrations en atomes implantés aux diverses énergies, pour que la concentration maximale en atomes implantés à l'une des énergies soit, avant traitement thermique, la plus proche possible de la concentration seuil, tout en implantant au total suffisamment d'atomes pour pouvoir faire croître et coalescer les microcavités et/ou générer les contraintes nécessaires pour avoir clivage.

D'une manière générale, on cherche à obtenir un profil de distribution de la concentration en fonction de la profondeur, présentant un pic avec un épaulement sur son versant le plus profond dans le substrat 1. Le pic doit être intense et bien défini pour optimiser la localisation de la zone de formation des microcavités. L'épaulement doit être bien renflé pour constituer un réservoir suffisamment important en atomes implantés. Ce résultat peut être obtenu de nombreuses manières en réalisant une multi-implantation à deux, trois, quatre énergies différentes, ou plus encore, pour implanter des atomes à deux, trois, quatre profondeurs, ou plus.

Afin que les atomes implantés ne diffusent pas rapidement hors de la zone située à la profondeur souhaitée ou même hors du matériau semi-conducteur lui-même, la température du substrat 1, est contrôlée et maintenue préférentiellement entre 20°C et 450°C pendant l'étape d'implantation. Cependant, après l'étape d'implantation, pour faire migrer les atomes implantés et les diverses espèces liées aux atomes implantés, vers la première profondeur, la température de traitement thermique est avantageusement supérieure à 150°C. Ce traitement thermique doit permettre, en plus de la migration des atomes implantés, un réarrangement cristallin et la coalescence des microcavités, le tout avec une cinétique appropriée.

Avantageusement, les atomes implantés aux première et deuxième profondeurs, se situent dans deux plans parallèles l'un à l'autre, et au maximum espacés l'un de l'autre d'une distance qui est sensiblement inférieure à la distance séparant le plan de la première profondeur de la surface 3 du substrat 1 ou la surface la plus proche du plan de la première profondeur. En effet, lors du traitement thermique, il y a migration des atomes implantés et des diverses espèces liées aux atomes implantés, il est alors nécessaire que les atomes implantés, et les diverses espèces liées aux atomes implantés, aux deuxième et troisième profondeurs puissent atteindre la zone de génération de cavités sans qu'une quantité significative des atomes implantés à la première profondeur n'ait atteint la surface 3 du substrat 1.

Pour de nombreuses applications, on cherche à obtenir un film mince 5 sur une grande surface, voire sur la totalité de la face 3 du substrat 1. Pour ce type d'application, un raidisseur 10 est parfois nécessaire. Le rôle du raidisseur 10 est, entre autre, de limiter l'effet, sur le film mince 5, des contraintes engendrées par la formation et la croissance des microcavités. Le choix de la méthode de fabrication de ce raidisseur 10 et de sa nature est effectué en fonction de chaque application visée pour le film mince. Par exemple, si l'application visée est celle décrite ci-dessus, c'est à dire la réalisation d'un film mince 5 de silicium sur un isolant, le raidisseur 10 est avantageusement un nouveau substrat de silicium recouvert d'oxyde. C'est alors l'oxyde qui est mis en contact intime avec le substrat 1. Ce raidisseur 10 peut être déposé directement sur le substrat 1, à l'aide de techniques de dépôt telles que l'évaporation, la pulvérisation, le dépôt chimique en phase vapeur, assisté ou non par plasma ou par photons, dès lors que l'épaisseur est modérée, c'est à dire de l'ordre de quelques micromètres à quelques dizaines de micromètres. Le raidisseur 10 peut aussi être collé au substrat 1, soit par une substance adhérant à la fois au raidisseur 10 et au substrat 1, soit par traitement thermique et/ou électrostatique assorti éventuellement d'une pression appropriée pour favoriser les liaisons interatomiques entre le raidisseur 10 et le substrat 1.

L'amélioration principale apportée par le mode de mise en oeuvre du procédé selon l'invention, décrit ci-dessus, par rapport à la technique antérieure, est de diminuer l'étendue en profondeur de la zone perturbée et/ou la rugosité sur le film mince 5.

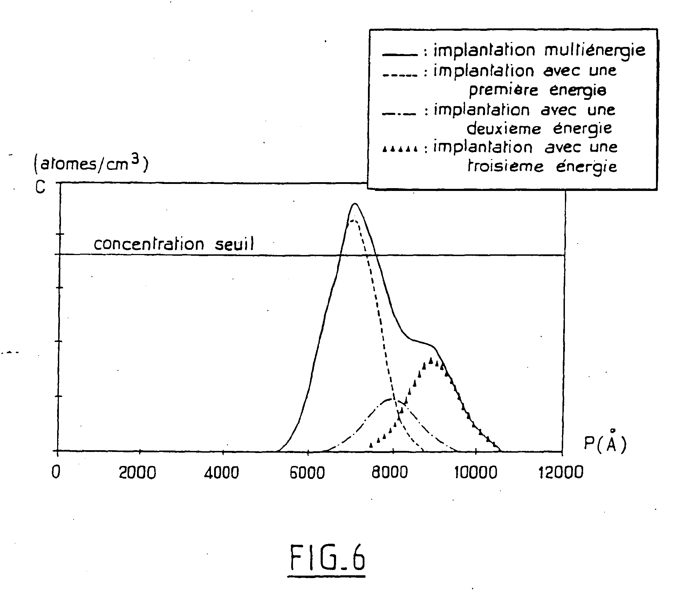

Selon une variante du mode de mise en oeuvre du procédé selon l'invention, décrit ci-dessus, la concentration maximale atteinte lors de l'implantation à la première énergie, est supérieure à la concentration seuil (figure 6). Dans ce cas, on obtient une largeur de la zone où la concentration est supérieure à la concentration seuil qui est plus large qu'avec le mode de mise en oeuvre précédemment décrit, mais le procesus de fabrication peut être accéléré par la diminution des temps de migration.

Pour certaines applications, on ne cherche pas nécessairement à réduire la largeur de la zone perturbée. Par exemple, pour réaliser des films très minces, on peut plutôt chercher à déplacer le barycentre du pic de concentration, vers la région du substrat 1 située du côté du plan de clivage qui comprendra le film mince 5. A cette fin, on réalise une implantation avec une première énergie pour implanter des atomes avec une concentration maximale, éventuellement supérieure à la concentration seuil. Ceci localise le film mince 5 entre la face 3 et le plan où sont implantés ces atomes. Puis on effectue au moins une autre implantation avec une deuxième énergie supérieure à la première énergie, mais de manière à ce que la concentration maximale reste inférieure à celle correspondant à la première énergie. De cette manière, les atomes implantés à l'énergie la plus élevée peuvent constituer un réservoir d'atomes implantés, et de diverses espèces liées aux atomes implantés, aptes à migrer vers la zone où la concentration en atomes implantés est supérieure. Ce réservoir est situé de l'autre côté du film mince 5, par rapport à cette dernière zone. Après clivage, les régions du substrat 1 perturbées par la formation du réservoir ne font pas partie du film mince 5. En outre, du fait de la réalisation du réservoir, le nombre d'atomes implantés à la première énergie peut être inférieur à ce qu'il devrait être pour une simple implantation. Donc, le pic correspondant à l'implantation à la première énergie peut être moins intense et moins large, ce qui localise mieux la zone où la concentration est supérieure à la concentration seuil, plus loin en profondeur. En déplaçant ainsi le début de cette zone, il est possible de réduire l'épaisseur des films minces 5 que l'on peut réaliser.

L'invention prend aussi tout son intérêt lorsque l'on veut implanter à plus haute énergie, par exemple lorsque le film mince 5 est recouvert d'une couche d'oxyde épaisse. En effet, plus l'énergie est élevée, plus la dispersion est grande et plus le pic de distribution de la concentration en fonction de la profondeur est large et, par conséquent, plus la zone perturbée est grande. L'invention, en permettant de limiter la largeur de la zone perturbée, permet de limiter les traitements destinés à ôter cette zone et permet d'obtenir des films minces 5 plus homogènes en épaisseur.

Dans ce qui précède, les qualificatifs « premier », « deuxième » et « troisième » ne sont pas utilisés pour spécifier un quelconque ordre opératoire. Ainsi, les implantations effectuées avec les deuxième et troisième énergies peuvent être réalisées avant celle effectuée à la première énergie.

Dans l'exemple de mise en oeuvre du procédé selon l'invention décrit ci-dessus et représenté sur la figure 1, celui-ci comprend une étape de traitement thermique permettant la diffusion des atomes et des diverses espèces liées aux atomes implantés, de la couche réservoir vers la couche de génération des microcavités. Cette étape de traitement thermique est réalisée après mise en contact intime du substrat 1 avec un raidisseur 10. Cependant, selon d'autres variantes du procédé selon l'invention, cette étape de traitement thermique est commencée pendant l'une des étapes, ou l'ensemble des étapes, d'implantation.

Selon encore d'autres variantes, cette étape de traitement thermique est commencée après implantation et est achevée au cours d'un recuit après mise en contact intime du substrat 1 avec un raidisseur 10.

Selon encore d'autres variantes, lorsque l'emploi d'un raidisseur 10 n'est pas nécessaire, cette étape de traitement thermique est réalisée entièrement pendant les étapes d'implantation, ou est commencée pendant les étapes d'implantation et achevée ensuite, etc.

Selon encore d'autres variantes, des étapes de traitement thermique sont intercalées entre les différentes étapes d'implantation.

Dans l'exemple de mise en oeuvre du procédé selon l'invention décrit ci-dessus, une seule espèce d'atomes, l'hydrogène, est utilisé. Pour certaines applications, il est avantageux que les atomes implantés soient des atomes de gaz rare. Avantageusement aussi, plusieurs espèces atomiques peuvent être utilisées pour un même traitement du substrat 1. Les autres espèces atomiques pouvant être utilisées sont par exemple, l'hélium, l'argon, le néon, le krypton ou le xénon. Mais on peut utiliser tout autre atome susceptible de créer des microcavités ou une zone de fragilisation dans le matériau qui subit le traitement.

Chaque espèce atomique peut être accélérée à une énergie différente ou même plusieurs espèces atomiques peuvent être accélérées avec la même énergie.

Dans l'exemple de mise en oeuvre du procédé selon l'invention, décrit ci-dessus, le clivage est obtenu grâce aux contraintes imposées par la croissance des microcavités et la coalescence de celles-ci. Ces effets sont induits par la migration, provoquée par le traitement thermique, des atomes implantés, et des diverses espèces liées aux atomes implantés, aux deuxième et troisième énergies. Ce traitement thermique peut être combiné avec une contrainte mécanique apte à faciliter ou provoquer un clivage au niveau des microcavités. Cette contrainte mécanique est, par exemple, générée par un effort de cisaillement, de traction, etc. ou des ultrasons. Cette variante de mise en oeuvre du procédé selon l'invention, est particulièrement utile lorsque l'on se contente de fragiliser le substrat 1 au niveau de la zone de génération de cavités, sans nécessairement faire croître ces microcavités jusqu'à leur coalescence et un clivage, par exemple eh n'utilisant le traitement thermique que pour faire migrer les atomes implantés et les diverses espèces liées aux atomes implantés du réservoir vers la zone de génération de cavités

Dans l'exemple de mise en oeuvre du procédé selon l'invention décrit ci-dessus, le matériau du substrat 1 est un semi-conducteur, et plus précisément du silicium monocristallin, poreux ou non. Mais le procédé selon l'invention est applicable à des substrats de tout autre matériau, semi-conducteur ou non (comme la silice par exemple), pris dans un état monocristallin, polycristallin, ou même amorphe. Ces différents états peuvent, par ailleurs, avoir été rendus poreux ou non.

Avantageusement aussi, le procédé selon l'invention peut être mis en oeuvre sur un substrat 1 comprenant sur sa face 3, au moins un élément lui conférant une structure hétérogène par la nature du matériau de cet élément ou par les reliefs que cet élément génère sur cette face 3. Cette structure hétérogène est par exemple constituée d'un composant électronique ou d'une structure multicouche homogène ou hétérogène.

Dans l'exemple de mise en oeuvre du procédé selon l'invention décrit ci-dessus, le matériau du raidisseur 10 est du silicium recouvert d'oxyde. Mais le procédé selon l'invention est applicable à des raidisseurs 10 de tout autre matériau, semi-conducteur ou non (comme la silice par exemple), pris dans un état monocristallin, polycristallin, ou même amorphe. Ces différents états peuvent, par ailleurs, avoir été rendus poreux ou non.

Avantageusement aussi, le procédé selon l'invention peut être mis en oeuvre avec un raidisseur 10 comprenant sur sa face de mise en contact avec le substrat 1, au moins un élément lui conférant une structure hétérogène par la nature du matériau de cet élément ou par les reliefs que cet élément génère sur cette face. Cette structure hétérogène est par exemple constituée d'un composant électronique ou d'une structure multicouche homogène ou hétérogène.

Dans l'exemple de mise en oeuvre du procédé selon l'invention décrit ci-dessus, et représenté sur la figure 1, celui-ci comprend une étape de mise en contact intime d'une face 3 du substrat 1 avec un raidisseur 10. Cependant un raidisseur 10 n'est pas toujours nécessaire. C'est le cas notamment lorsque la zone de génération de microcavités est assez profonde pour que la partie située entre cette zone et la face 3 soit suffisamment épaisse pour jouer elle-même le rôle de raidisseur. Ce film 5, obtenu de cette manière, est alors qualifié de « structure autoportée ».

Le procédé selon l'invention est aussi applicable à des substrats 1 d'isolant, de supraconducteur, etc. D'une manière générale, il sera avantageusement utilisé avec les matériaux pour fabriquer des composants électroniques, optiques ou opto-électroniques.

## Revendications

1. Procédé de traitement de substrats, notamment semi-conducteurs, par implantation d'atomes, dans le but de créer dans un substrat (1) des cavités à une profondeur contrôlée comprenant les étapes consistant à :
- implanter des atomes dans le substrat (1) à une première profondeur, pour obtenir une première concentration d'atomes à cette première profondeur
- implanter des atomes dans le substrat (1) à une deuxième profondeur différente de la première, pour obtenir à cette deuxième profondeur, une deuxième concentration d'atomes, inférieure à la première, et former un réservoir d'atomes ;
- effectuer sur le substrat (1), un traitement mis en oeuvre pour faire migrer vers la première profondeur, au moins une partie des atomes implantés du réservoir de la deuxième profondeur, de manière à générer les cavités à la première profondeur.

2. Procédé selon la revendication 1, **caractérisé par le fait que** le traitement mis en oeuvre pour faire migrer au moins une partie des atomes implantés, est aussi mis en oeuvre pour reporter, vers la première profondeur, des perturbations structurelles et des espèces chimiques liées aux atomes implantés, créées à la deuxième profondeur par les atomes implantés à cette deuxième profondeur.

3. Procédé selon l'une des revendications précédentes, **caractérisé par le fait que** le traitement apte à faire migrer au moins une partie des atomes implantés à la deuxième profondeur et à reporter, vers la première profondeur, des perturbations structurelles et des espèces chimiques liées aux atomes implantés, est un traitement thermique.

4. Procédé selon l'une des revendications précédentes, **caractérisé par le fait que** les cavités formées à la première profondeur constituent une zone de fragilisation, au niveau de laquelle peut être effectué un clivage du substrat (1).

5. Procédé selon l'une des revendications 1 à 3, **caractérisé par le fait qu'**il est appliqué au traitement de substrats destinés à la réalisation de composants électroluminescents ou photoluminescents.

6. Procédé selon l'une des revendications précédentes, **caractérisé par le fait que** les atomes implantés sont des atomes d'hydrogène ou de gaz rare.

7. Procédé selon l'une des revendications précédentes, **caractérisé par le fait que** plusieurs espèces atomiques sont utilisées pour un même traitement du substrat (1).

8. Procédé selon l'une des revendications précédentes, **caractérisé par le fait qu'**au moins une étape consistant à faire pénétrer des atomes dans le substrat (1) est réalisée par bombardement ionique.

9. Procédé selon l'une des revendications 1 à 8, **caractérisé par le fait qu**'au moins une des étapes d'implantation des atomes dans le substrat (1) est réalisée par immersion du substrat (1) dans un plasma.

10. Procédé selon l'une des revendications précédentes, **caractérisé en ce que** les atomes sont respectivement implantés aux première et deuxième profondeurs, dans deux plans parallèles l'un à l'autre, et au maximum espacés l'un de l'autre d'une distance qui est sensiblement inférieure à la distance séparant le plan situé à la première profondeur de la surface (3) du substrat (1) la plus proche de celui-ci.

11. Procédé selon l'une des revendications précédentes **caractérisé par le fait que** l'on réalise une multi-implantation, pour implanter des atomes à plusieurs profondeurs différentes, de manière à obtenir un profil de distribution de la concentration présentant un pic avec un épaulement sur son versant le plus profond.

12. Procédé selon l'une des revendications précédentes **caractérisé en ce que** l'on réalise l'implantation des atomes à trois profondeurs différentes.

13. Procédé selon l'une des revendications précédentes, **caractérisé en ce que** le nombre d'atomes implantés à la première profondeur est supérieure au nombre d'atomes implantés aux deuxième et troisième profondeurs, et **en ce que** le nombre d'atomes implantés à la deuxième profondeur est inférieur au nombre d'atomes implantés à la troisième profondeur.

## Claims

1. Process for treating substrates, especially semiconductor substrates, by atom implantation for the purpose of creating cavities in a substrate (1) at a controlled depth, comprising the steps consisting in:
- implanting atoms into the substrate (1) at a first depth, in order to obtain a first atom concentration at this first depth;
- implanting atoms into the substrate (1) at a second depth different from the first, in order to obtain, at this second depth, a second atom concentration less than the first, and form a reservoir of atoms;
- carrying out, on the substrate (1), a treatment implemented to make at least some of the implanted atoms of the reservoir of the second depth migrate toward the first depth, so as to generate the cavities at the first depth.

2. Process according to Claim 1, **characterized in that** the treatment implemented to make at least some of the implanted atoms migrate is also implemented to transfer, toward the first depth, structural perturbations and chemical species linked to the implanted atoms, these being created at the second depth by the atoms implanted at this second depth.

3. Process according to either of the preceding claims, **characterized in that** the treatment capable of making at least some of the atoms implanted at the second depth migrate and of transferring, toward the first depth, structural perturbations and chemical species linked to the implanted atoms, is a heat treatment.

4. Process according to any one of the preceding claims, **characterized in that** the cavities formed at the first depth constitute an embrittlement region within which cleavage of the substrate (1) may take place.

5. Process according to one of Claims 1 to 3, **characterized in that** it is applied to the treatment of substrates intended for the production of electroluminescent or photoluminescent components.

6. Process according to one of the preceding claims, **characterized in that** the implanted atoms are hydrogen or rare gas atoms.

7. Process according to one of the preceding claims, **characterized in that** several atomic species are used for the same treatment of the substrate (1).

8. Process according to one of the preceding claims, **characterized in that** at least one step consisting in making atoms penetrate the substrate (1) is carried out by ion bombardment.

9. Process according to one of Claims 1 to 8, **characterized in that** at least one of the steps of implanting the atoms into the substrate (1) is carried out by immersing the substrate (1) in a plasma.

10. Process according to one of the preceding claims, **characterized in that** the atoms are implanted at the first and second depths, respectively, in two mutually parallel planes, and at most separated from each other by a distance which is substantially less than the distance separating the plane lying at the first depth from the surface (3) of the substrate (1) closest to the latter.

11. Process according to one of the preceding claims, **characterized in that** a multiple implantation is carried out in order to implant atoms at several different depths so as to obtain a concentration distribution profile having a peak with a shoulder on its deepest side.

12. Process according to one of the preceding claims, **characterized in that** the implantation of the atoms is carried out at three different depths.

13. Process according to one of the preceding claims, **characterized in that** the number of atoms implanted at the first depth is greater than the number of atoms implanted at the second and third depths, and **in that** the number of atoms implanted at the second depth is less than the number of atoms implanted at the third depth.

## Patentansprüche

1. Verfahren zur Bearbeitung von Substraten, insbesondere HalbleiterSubstraten, mittels Implantation von Atomen, mit dem Ziel, in einem Substrat (1) Hohlräume in einer kontrollierten Tiefe zu erzeugen, das die Schritte umfasst, die aus folgendem bestehen:
- Implantieren von Atomen im Substrat (1) in einer ersten Tiefe, um eine erste Konzentration von Atomen in dieser ersten Tiefe zu erhalten;
- Implantieren von Atomen im Substrat (1) in einer zweiten Tiefe, die von der ersten verschieden ist, um in dieser zweiten Tiefe eine zweite Konzentration von Atomen zu erhalten, die geringer ist als die erste, und einen Atomvorrat zu bilden;
- Durchführen einer Behandlung am Substrat (1), die eingesetzt wird, um wenigstens einen Teil der implantierten Atome des Vorrats der zweiten Tiefe derart in Richtung der ersten Tiefe wandern zu lassen, dass in der ersten Tiefe die Hohlräume erzeugt werden.

2. Verfahren nach Anspruch 1, **dadurch gekennzeichnet, dass** die Behandlung, die eingesetzt wird, um wenigstens einen Teil der implantierten Atome wandern zu lassen, auch eingesetzt wird, um strukturelle Störungen und chemische Arten, die mit den implantierten Atomen verbunden sind und die in der zweiten Tiefe von den in dieser zweiten Tiefe implantierten Atomen erzeugt werden, in Richtung der ersten Tiefe zu übertragen.

3. Verfahren nach einem der vorhergehenden Ansprüche, **dadurch gekennzeichnet, dass** die Behandlung, die dafür geeignet ist, wenigstens einen Teil der in der zweiten Tiefe implantierten Atome wandern zu lassen und strukturelle Störungen und chemische Arten, die mit den implantierten Atomen verbunden sind, in Richtung der ersten Tiefe zu übertragen, eine thermische Behandlung ist.

4. Verfahren nach einem der vorhergehenden Ansprüche, **dadurch gekennzeichnet, dass** die in der ersten Tiefe gebildeten Hohlräume eine Schwächungszone bilden, in deren Bereich eine Spaltung des Substrats (1) ausgeführt werden kann.

5. Verfahren nach einem der Ansprüche 1 bis 3, **dadurch gekennzeichnet, dass** es bei der Behandlung von Substraten angewendet wird, die für die Herstellung von Komponenten mit Elektrolumineszenz oder Fotolumineszenz vorgesehen sind.

6. Verfahren nach einem der vorhergehenden Ansprüche, **dadurch gekennzeichnet, dass** die implantierten Atome Wasserstoffatome oder Edelgasatome sind.

7. Verfahren nach einem der vorhergehenden Ansprüche, **dadurch gekennzeichnet, dass** für ein und dieselbe Behandlung des Substrats (1) mehrere Atomsorten verwendet werden.

8. Verfahren nach einem der vorhergehenden Ansprüche, **dadurch gekennzeichnet, dass** wenigstens ein Schritt, der darin besteht Atome in das Substrat (1) eindringen zu lassen, durch Ionenbombardement realisiert wird.

9. Verfahren nach einem der Ansprüche 1 bis 8, **dadurch gekennzeichnet, dass** wenigstens einer der Schritte zur Implantation von Atomen im Substrat (1) durch das Eintauchen des Substrats (1) in ein Plasma realisiert wird.

10. Verfahren nach einem der vorhergehenden Ansprüche, **dadurch gekennzeichnet, dass** die Atome in der ersten bzw. der zweiten Tiefe in zwei zueinander parallelen Ebenen implantiert werden, die voneinander maximal durch einen Abstand getrennt sind, der deutlich kleiner ist als der Abstand, der die bei der ersten Tiefe angeordnete Ebene von der Oberfläche (3) des Substrats (1) trennt, die dieser am nächsten gelegen ist.

11. Verfahren nach einem der vorhergehenden Ansprüche, **dadurch gekennzeichnet, dass** eine Mehrfach-Implantation ausgeführt wird, um Atome in mehreren verschiedenen Tiefen zu implantieren, derart, dass ein Verteilungsprofil der Konzentration erhalten wird, das einen Spitzenwert mit einem Absatz auf seiner am tiefsten gelegenen Flanke hat.

12. Verfahren nach einem der vorhergehenden Ansprüche, **dadurch gekennzeichnet, dass** die Implantation der Atome in drei verschiedenen Tiefen ausgeführt wird.

13. Verfahren nach einem der vorhergehenden Ansprüche, **dadurch gekennzeichnet, dass** die Anzahl der in der ersten Tiefe implantierten Atome größer ist als die Anzahl der in der zweiten und dritten Tiefe implantierten Atome und **dadurch**, dass die Anzahl der in der zweiten Tiefe implantierten Atome kleiner ist als die Anzahl der in der dritten Tiefe implantierten Atome.
